# FASCICULE DE BREVET EUROPEEN

(11) **EP 3 264 541 B1**
(45) Date de publication et mention de la délivrance du brevet: **09.01.2019**
(21) Numéro de dépôt: 17178538.9
(22) Date de dépôt: 28.06.2017
(51) Int. Cl.: H01S 5/02, H01S 5/024, H01S 5/026, H01S 5/183, H01S 5/50

(54) **SOURCE LASER À SEMI-CONDUCTEUR**
LASERQUELLE MIT HALBLEITER
SEMICONDUCTOR LASER SOURCE

(30) Priorité: 30.06.2016 FR 1656174
(43) Date de publication de la demande: 03.01.2018
(73) Titulaire: COMMISSARIAT À L'ÉNERGIE ATOMIQUE ET AUX ÉNERGIES ALTERNATIVES, 75015 Paris (FR)
(72) Inventeur: SCIANCALEPORE, Corrado, 69002 Lyon (FR); CASALE, Marco, 38000 Grenoble (FR)
(74) Mandataire: Colombo, Michel

(56) Documents cités:
- US-A1- 2009 168 821
- US-A1- 2016 047 986
- US-A1- 2016 094 014
- MATTHEW N SYSAK ET AL: "Reduction of hybrid silicon laser thermal impedance using poly Si thermal shunts", GROUP IV PHOTONICS (GFP), 2010 7TH IEEE INTERNATIONAL CONFERENCE ON, IEEE, PISCATAWAY, NJ, USA, 1 septembre 2010 (2010-09-01), pages 296-298, XP031806882, ISBN: 978-1-4244-6344-2

## Description

L'invention concerne une source laser à semi-conducteur apte à émettre à au moins une longueur d'onde λ_{Li}. L'invention concerne également un procédé de fabrication de cette source laser.

Les sources laser à semi-conducteur compatibles avec la technologie CMOS connues comportent un amplificateur optique déposé (ou reporté) sur une couche structurée comportant au moins un composant optique passif. Dans ces sources laser connues, l'amplificateur optique transforme une partie de l'énergie électrique qu'il consomme en chaleur. Pour conserver constantes les caractéristiques d'émission et augmenter la plage de fonctionnement de la source laser, cette chaleur doit être dissipée. La plage de fonctionnement désigne ici une plage de températures à l'intérieur de laquelle le spectre d'émission de la source laser est quasiment constant. Toutefois, dans des sources laser connues compatibles avec la technologie CMOS, la couche structurée est une couche de silice (SiO₂) à l'intérieur de laquelle, ou sur laquelle, le composant optique passif a été fabriqué. Ainsi l'amplificateur optique est isolé mécaniquement du substrat en silicium par cette couche structurée essentiellement réalisée en silice. Or, la silice est un mauvais conducteur thermique. Par « mauvais conducteur thermique » on désigne ici un matériau dont la conductivité thermique à 20°C est inférieure ou égale à 1,5 W/m/K ou 1,3 W/m/K. Ainsi, dans ces sources laser connues, l'amplificateur optique est également thermiquement isolé du substrat en silicium. Ceci ne favorise pas la dissipation de la chaleur.

Par ailleurs, à ce jour, la silice demeure le choix le plus pratique pour fabriquer la couche structurée car elle est facile à déposer et à graver avec les techniques de fabrication développées pour la technologie CMOS (« Complementary Metal Oxide Semi-conductor »). Par exemple, la silice est bien plus pratique à déposer et à graver que le nitrure d'aluminium qui présente un indice de réfraction acceptable pour encapsuler et réaliser des composants optiques passifs. En effet, le dépôt et la gravure du nitrure d'aluminium nécessitent la mise en oeuvre d'équipements spéciaux, ce qui complexifie la fabrication de la source laser. Par contre, le nitrure d'aluminium présente une bonne conductivité thermique. Par « bonne conductivité thermique », on désigne ici une conductivité thermique à 20°C supérieure ou égale à 5 W/m/K et, de préférence, supérieure ou égale à 20 W/m/K et donc bien supérieure à celle de la silice.

Plus récemment, une autre solution a été proposée dans l'article suivant : Matthew N. Sysak et Al., « Reduction of hybrid silicon laser thermal impedance using poly Si Thermal shunts », Conférence on Optical Fiber Communication - OFC 2011 Collocated National Fiber Optic Engineers Conférence OFC/NFOEC, 2011, pages 15041. Par la suite, cet article est désigné par l'abréviation Sysak2011.

Plus précisément, cet article, décrit une source laser comportant :
- un substrat en silicium s'étendant principalement dans un plan appelé « plan du substrat »,
- une couche structurée formée sur une face supérieure du substrat en silicium et présentant une face supérieure du côté opposé au substrat en silicium, cette couche structurée comportant :
   - un composant optique passif choisi dans le groupe composé d'un réflecteur optique et d'un guide d'onde, ce composant optique passif étant encapsulé dans de la silice ou réalisé sur une couche de silice, et
   - au moins un plot s'étendant depuis une face inférieure, en contact direct avec le substrat en silicium, jusqu'à une face supérieure affleurant la face supérieure de la couche structurée, ce plot étant entièrement réalisé dans un matériau dont la conductivité thermique à 20°C est supérieure à la conductivité thermique à 20°C de la silice pour former un pont thermique à travers la couche structurée,
- un amplificateur optique en matériau III-V apte à amplifier le signal optique de longueur d'onde λ_{Li} qui le traverse lorsqu'il est alimenté, cet amplificateur optique étant directement collé, par collage direct, sur la face supérieure de la couche structurée au-dessus, dans une direction perpendiculaire au plan du substrat, du composant optique passif de manière à ce que le signal optique amplifié par l'amplificateur optique soit réfléchi ou guidé par ce composant optique passif, cet amplificateur optique étant également directement collé, par collage direct, au moins en partie sur la face supérieure du plot pour dissiper la chaleur qu'il génère vers le substrat en silicium.

Le collage direct est connu sous le terme anglais de « direct bonding ». Il s'agit d'un collage entre deux matériaux sans présence de matériau supplémentaire comme une colle polymérisable. À faible température, la force de collage est essentiellement due à des forces de Van Der Waals. Après un recuit à plus de 150° ou 400°C, des liaisons covalentes apparaissent entre les faces collées et la force de collage est alors beaucoup plus importante.

Dans l'article de Sysak2011, le plot est en polysilicium présente une conductivité thermique à 20°C de l'ordre de 30 W/m/K. Puisque ce plot est directement en contact, d'un côté, avec l'amplificateur optique et, de l'autre côté, avec le substrat en silicium, il forme un pont thermique qui traverse la couche structurée et qui favorise la dissipation de la chaleur de l'amplificateur optique vers le substrat en silicium. De plus, la solution proposée dans l'article Sysak2011 présente l'avantage de conserver la silice comme matériau utilisé pour la réalisation du composant optique passif.

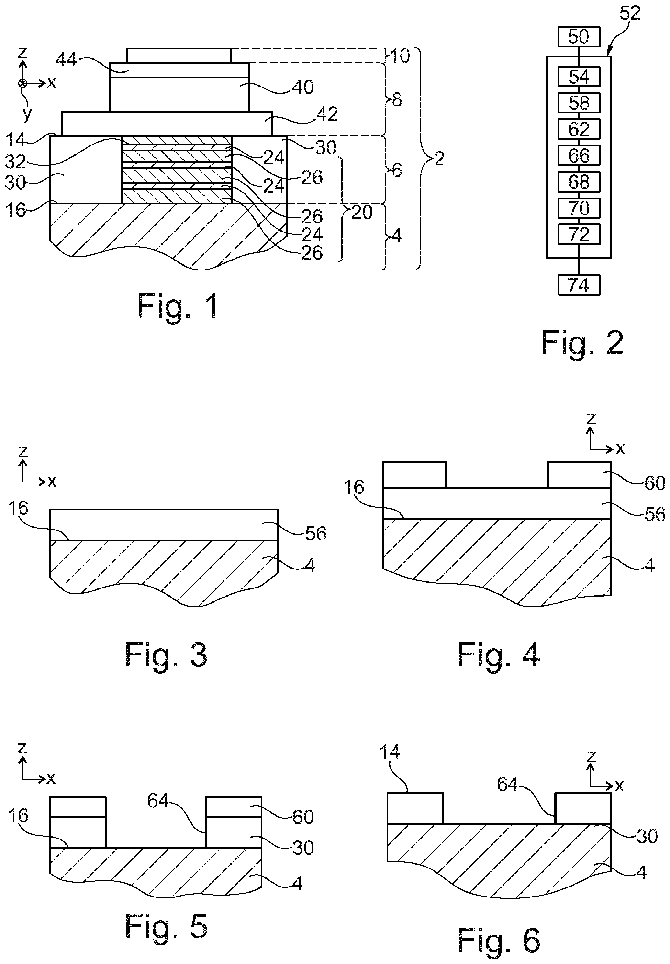

Toutefois, comme le montre la comparaison des graphes de la figure 1 de cet article, pour la même intensité du courant de biais (« bias current » en anglais) et pour la même température de fonctionnement, la puissance de sortie de la source laser qui comporte le plot en polysilicium est réduite. Autrement dit, à cause de l'intégration du plot en polysilicium, la source laser consomme plus de courant pour délivrer la même puissance. L'intégration des plots en polysilicium impacte donc le comportement optique de la source.

De l'état de la technique est également connu de :
- US2009/168821A1,
- US2016/047986A1,
- US2016/094014A1.

L'invention vise à remédier à cet inconvénient tout en préservant les avantages de la source laser décrite dans l'article Sysak2011. Elle a donc pour objet une source laser dans laquelle le plot est réalisé en nitrure de silicium (Si3N4).

Dans l'état des connaissances actuelles, il est supposé que l'augmentation des pertes optiques lorsque le plot en polysilicium est utilisé pour dissiper la chaleur vers le substrat en silicium provient en partie du fait que le collage de l'amplificateur optique sur la face supérieure de ce plot présente des caractéristiques inappropriées. Par exemple, il est subodoré que la face supérieure du plot en polysilicium est rugueuse, ce qui se traduit par une force de collage dégradée entre l'amplificateur optique et la face supérieure de la couche structurée.

La source laser revendiquée remédie à ce problème en remplaçant le polysilicium par du nitrure de silicium. Actuellement, une hypothèse pour expliquer les bons résultats obtenus est la suivante : contrairement au polysilicium, la disparité de la taille des grains à l'intérieur du nitrure de silicium est beaucoup plus faible. Dès lors, à polissage égal, la face supérieure du plot en nitrure de silicium est beaucoup plus lisse et moins rugueuse que la face supérieure d'un plot en polysilicium. Par conséquent, la qualité du collage direct de l'amplificateur optique sur la face supérieure du plot en nitrure de silicium est meilleure. Cela se traduit par une diminution des pertes optiques par rapport au cas où ce même plot aurait été réalisé en polysilicium. De plus, étant donné que la conductivité thermique du nitrure de silicium est similaire à celle du polysilicium, la dissipation de la chaleur de l'amplificateur optique vers le substrat en silicium est aussi efficace que dans la source laser décrite dans l'article Sysak2011.

Comme dans la solution proposée dans l'article Sysak2011, l'utilisation du plot en nitrure de silicium permet de conserver la possibilité de fabriquer le composant optique passif en utilisant de la silice. Ainsi, cette source laser peut être fabriquée en utilisant les mêmes techniques que celles développées pour la technologie CMOS. La source laser revendiquée présente donc les mêmes avantages que celle décrite dans l'article Sysak2011.

Enfin, l'emploi du nitrure présente un avantage important dans la fabrication des plots pour la dissipation thermique. En effet ce matériau est plus dur que la silice et que le silicium. Le plot en nitrure de silicium joue ainsi en plus le rôle de couche d'arrêt lors du polissage de la face supérieure de la couche structurée. Grâce à cela, le polissage ne peut pas affecter le composant optique passif de la couche structurée.

Les modes de réalisation de cette source laser peuvent comporter une ou plusieurs des caractéristiques des revendications dépendantes.

Ces modes de réalisation de la source laser présentent en outre un ou plusieurs des avantages suivants :
- La présence d'un film en silice situé au-dessus du composant optique passif et qui affleure la face supérieure de la couche structurée améliore le collage direct de l'amplificateur optique sur cette couche structurée par rapport au cas où une zone est laissée vide comme dans la source laser de l'article de Sysak2011. Cela réduit donc encore plus les pertes optiques de la source laser revendiquée.

L'invention a également pour objet un procédé de fabrication de la source laser revendiquée.

Les modes de réalisation du procédé de fabrication peuvent présenter en outre l'avantage suivant :
- Étant donné que le nitrure de silicium est plus dur que la silice et le silicium, le plot en nitrure de silicium permet d'arrêter précisément le polissage à la hauteur souhaitée, ce qui empêche tout polissage excessif susceptible d'endommager le composant optique passif.

L'invention sera mieux comprise à la lecture de la description qui va suivre, donnée uniquement à titre d'exemple non limitatif et faite en se référant aux dessins sur lesquels :
- la figure 1 est une illustration schématique, en coupe verticale, d'une source laser à émission verticale (perpendiculaire au substrat) de type VCSEL (« Vertical Cavity Surface Emitting Laser »);
- la figure 2 est un organigramme d'un procédé de fabrication de la source laser de la figure 1 ;
- les figures 3 à 9 sont des illustrations schématiques, en coupe verticale, de différentes étapes de fabrication de la source laser lors de la mise en oeuvre du procédé de la figure 2 ;
- les figures 10 et 11 sont des illustrations schématiques, en coupe verticale, de deux autres modes de réalisation possibles de la source laser.

Dans ces figures, les mêmes références sont utilisées pour désigner les mêmes éléments. Dans la suite de cette description, les caractéristiques et fonctions bien connues de l'homme du métier ne sont pas décrites en détail.

Un exemple préféré de réalisation va maintenant être décrit dans le cas particulier d'une source laser à émission verticale réalisée sur substrat de silicium à l'aide de technologies compatibles avec la technologie CMOS (Complementary Metal Oxide Semiconductor).

La figure 1 représente une source laser 2 connue sous l'acronyme VCSEL (« Vertical Cavity Surface Emitting Laser ») ou diode laser à cavité verticale émettant en surface. L'architecture et le fonctionnement général d'une telle source laser est bien connue et seuls les détails nécessaires à la compréhension de l'invention sont décrits ici. Une telle source laser émet un signal optique cohérent à une longueur d'onde λ_{Li} typiquement comprise entre 1250 nm et 1650 nm.

Dans la figure 1, la source laser 2 est représentée en coupe verticale le long d'un plan vertical XZ. Dans cette figure et les suivantes, la direction verticale est représentée par la direction Z d'un repère orthogonal XYZ. Les directions X et Y sont des directions horizontales. Par la suite, dans ce texte, les termes tels que « supérieur », « inférieur », « haut », « bas », « dessus », « dessous » sont définis par rapport à la direction Z. Dans cette figure 1 et les suivantes, les différents éléments de la source laser ne sont pas représentés à l'échelle pour améliorer la lisibilité de ces figures.

La source laser 2 comporte, en partant du bas vers le haut :
- un substrat massif 4 en silicium qui s'étend principalement dans un plan horizontal appelé « plan du substrat »,
- une couche structurée 6 directement déposée sur le substrat 4,
- un amplificateur optique 8 directement déposé sur la couche structurée 6, et
- un réflecteur supérieur 10 déposé sur l'amplificateur optique 8.

Dans cette description, l'expression « couche en matériau X » ou « réalisé en matériau X » signifie que la couche ou l'élément est composé à plus de 95 % ou 98 % en masse du matériau X.

Typiquement, l'épaisseur du substrat 4 est supérieure ou égale à 250 µm ou 500 µm. Ici, l'épaisseur du substrat 4 est de 725 µm.

L'épaisseur de la couche 6 dépend de la longueur d'onde λ_{Li}. Typiquement, l'épaisseur de la couche structurée 6 est inférieure à 2,5 µm. Par exemple, son épaisseur peut être supérieure à 100nm ou 500 nm. Par exemple, l'épaisseur de la couche structurée 6 est égale à 1 µm à plus ou moins 15 % près. La couche structurée 6 s'étend depuis une face inférieure horizontale 16 du substrat 4 jusqu'à une face supérieure horizontale 14 située du côté opposé au substrat 4.

La couche structurée 6 comporte un ou plusieurs composants optiques passifs. Ici, l'un de ces composants optique passifs est un réflecteur inférieur 20. le réflecteur 20 forme avec le réflecteur 10 une cavité optique à l'intérieur de laquelle résonne le signal optique à la longueur d'onde λ_{Li} avant d'être émis par la source laser 2.

Typiquement, le réflecteur 20 est un miroir de Bragg ou un réseau de Bragg. Il est donc formé par un empilement, dans la direction Z, en alternance, d'une couche à faible indice de réfraction et d'une couche à fort indice de réfraction. Ici, le réflecteur 20 est formé d'un empilement, en alternance, d'une couche 24 en silicium amorphe et d'une couche 26 en silice (SiO₂). Typiquement, l'épaisseur de chaque couche 24, 26 est proportionnelle à la longueur d'onde λ_{Li}. Par exemple, l'épaisseur de chacune de ces couches 24, 26 est égale à λ_{Li}/(4*nᵢ*) où *nᵢ* est l'indice de réfraction de l'i-ème couche. Le nombre de fois où l'alternance des couches 24, 26 est répétée dans l'empilement est évalué entre 2 et 4 alternances et démie. Ici, pour simplifier la figure 1 et les suivantes, seules quelques couches 24 et 26 ont été représentées.

La couche structurée 6 comporte aussi un plots 30 en nitrure de silicium stoechiométrique (Si₃N₄). Ici, dans un plan horizontal, ce plot 30 entoure complètement le réflecteur 20. Le plot 30 s'étend verticalement, depuis une face inférieure qui repose directement sur la face 16 du substrat 4 jusqu'à une face supérieure affleurant la face 14. Ici, la face supérieure du plot 30 est contenue dans le plan horizontal dans lequel s'étend la face supérieure 14.

Le plot 30 traverse donc verticalement de part en part la couche structurée 6. Pour rappel, la conductivité thermique du nitrure de silicium à 20°C est supérieure ou égale à 24 W/m/K et, généralement, égale à 30 W/m/K à plus ou moins 15 % près. Sa conductivité thermique est donc très supérieure à la conductivité thermique de la silice qui est de l'ordre de 1,3 W/m/K et sensiblement égale à celle du polysilicium. Le plot 30 forme donc un pont thermique qui relie directement la face supérieure 14 au substrat 4 car sa résistance thermique est très inférieure à celle du réflecteur 20.

La couche structurée 6 comporte aussi un film 32 en silice uniquement interposée entre le réflecteur 20 et la face 14. Ce film 32 affleure la face 14. Ce film 32 forme un tampon apte à absorber l'hydrogène libéré lors du collage direct de l'amplificateur optique 8 sur la face 14.

Ici, l'épaisseur du film 32 est supérieure ou égale à 10 nm ou 50 nm et, de préférence, comprise entre 50 nm et 100 nm ou entre 75 et 100 nm.

L'amplificateur optique 8 amplifie le signal optique à la longueur d'onde λ_{Li} qui résonne dans la cavité optique délimitée par les réflecteurs 10 et 20 lorsqu'il est alimenté. Un tel amplificateur optique est plus connu sous l'acronyme SOA (« Semi-conductor Optical Amplifier »). À cet effet, il comporte une région active 40 interposée entre une électrode inférieure 42 et une électrode supérieure 44.

La région active 40 est formée d'un ou plusieurs puits quantiques en matériau III-V. Par exemple, la région active 40 est formée d'un empilement, dans la direction Z, en alternance, de couches en InGaAs et de couches en GaAs.

Les électrodes 42 et 44 sont par exemple réalisées en GaAs. L'électrode 42 présente un dopage de signe opposés à l'électrode 44. De plus, la largeur de l'électrode 42 dans au moins une direction horizontale est supérieure à la largeur, dans la même direction, de la région active 40 et de l'électrode 44. Ainsi, l'électrode 42 dépasse, ici dans la direction X, des deux côtés de la région active 40. Par exemple, l'électrode 42 dépasse la région active, dans la direction X, d'au moins 10 µm ou 30 µm. Ici, l'électrode 42 dépasse de 50 µm de chaque côté de la région active. De la même façon, l'électrode 42 dépasse de la région active dans la direction Y.

L'électrode 42 est directement collée, par collage direct, sur la face supérieure 14 au-dessus du réflecteur 20. Plus précisément, l'électrode 42 est directement collée sur le film 32 et sur la face supérieure du plot 30. Typiquement, l'électrode 42 recouvre complètement le film 32 et s'étend directement sur la face supérieure du plot 30 sur une distance supérieure ou égale à 5 µm et, de préférence, supérieure ou égale à 10 µm ou 20 µm. Ici, l'électrode 42 s'étend sur la face supérieure du plot 30, de chaque côté du réflecteur 20 et dans les directions X et Y sur une distance supérieure à 50 µm.

Des prises de contact électrique, non représentées sur les figures, viennent directement en contact mécanique sur les extrémités de l'électrode 42 qui dépassent pour appliquer un potentiel sur cette électrode 42. De façon similaire, au moins une prise de contact électrique, non représentée sur les figures, vient directement en contact mécanique sur l'électrode 44 pour appliquer un autre potentiel sur cette électrode 44. La différence de potentiels appliquée entre les électrodes 42 et 44 permet d'alimenter la région active 40.

Le réflecteur 10 est directement déposé sur l'électrode 44. Ce réflecteur 10 a une structure similaire (par exemple un cristal photonique) ou identique à celle déjà décrite pour le réflecteur 20.

Lorsque la région active 40 est alimentée, une partie de l'énergie électrique consommée est transformée en chaleur. Ici, cette chaleur se propage par conduction thermique à travers l'électrode 42 et le plot 30 jusqu'au substrat 4. Cela limite ainsi l'échauffement de l'amplificateur optique 8 et limite la dérive en température des caractéristiques de fonctionnement de la source laser 2. De plus, puisque le plot 30 est en nitrure de silicium et non pas en polysilicium la qualité du collage direct de l'amplificateur optique 8 sur la face 14 est améliorée, ce qui limite les pertes optiques.

Un procédé de fabrication de la source laser 2 va maintenant être décrit en référence aux figures 2 à 9.

Ce procédé débute par une étape 50 de fourniture du substrat 4 en silicium.

Ensuite, lors d'une étape 52, la couche structurée 6 est réalisée directement sur la face supérieure 16 du substrat 4.

Pour cela, lors d'une opération 54, une couche 56 (figure 3) de nitrure de silicium est directement déposée sur la face supérieure 16 du substrat 4. Par exemple, elle est déposée par la technique connue sous l'acronyme LPCVD (« Low Pressure Chemical Vapor Déposition »). Ce dépôt peut éventuellement être répété pour atteindre l'épaisseur requise pour la couche 56. L'épaisseur de la couche 56 est égale à l'épaisseur du plot 30.

Lors d'une opération 58, un masque 60 (figure 4) en résine est réalisé sur la couche 56. A cet effet, une couche de résine est déposée puis une partie de cette couche est éliminée à l'emplacement où doit être gravée une cavité dans la couche 56.

Lors d'une opération 62, la couche 56 est gravée à travers le masque 60 pour former une cavité 64 (figure 5) dans la couche 56. Cette cavité 64 traverse de part en part la couche 56. Ici, le fond de la cavité 64 est formé par la face supérieure 16 du substrat 4. Les parties non gravées de la couche 56 forment alors le plot 30 qui s'étend tout autour de la cavité 64.

Lors d'une opération 66, le masque 60 est éliminé (figure 6).

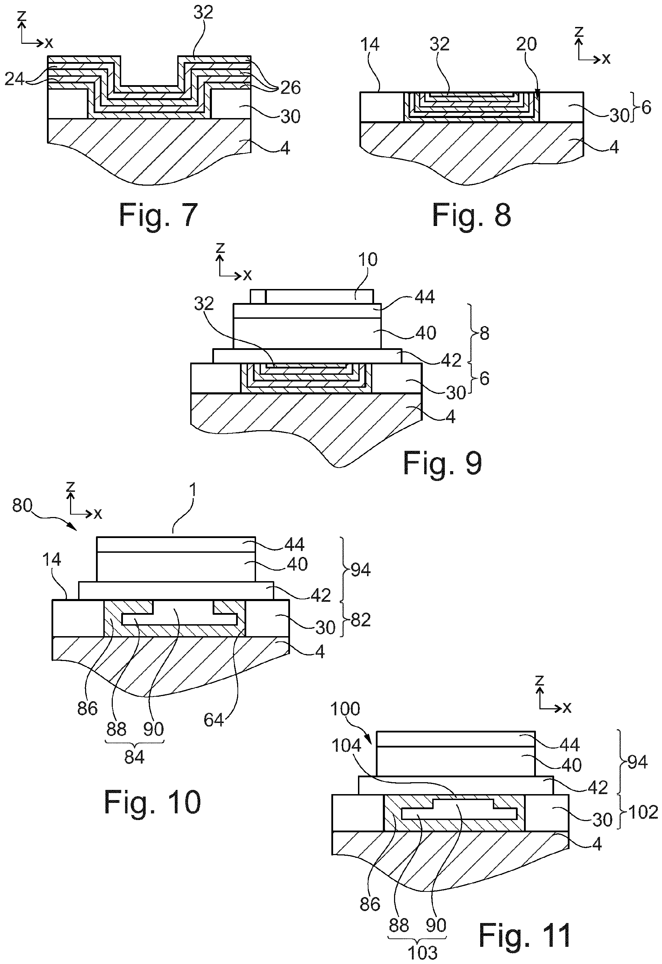

Lors d'une opération 68, le réflecteur 20 est réalisé à l'intérieur de la cavité 64. Pour cela, les couches 24 et 26 du réflecteur 20 sont déposées les unes après les autres pour former l'empilement de couches qui constitue ce réflecteur 20 (figure 7). Lors de cette opération, les couches 24 et 26 sont déposées sur l'ensemble de la surface du substrat 4. Elles s'étendent donc de part et d'autre de la cavité 64. De plus, chaque couche 24, 26 présente, avant de s'étendre sur le fond de la cavité 64, des sections sensiblement parallèles aux parois verticales de cette cavité 64. Ces sections améliorent le fonctionnement du réflecteur 20 par rapport au cas d'un réflecteur dépourvu de telles sections. Pour simplifier la figure 1, ces sections verticales des couches 24 et 26 ont uniquement été représentées sur les figures 7 à 9. De plus, pour simplifier les figures 7 à 9, le nombre de couches 24, 26 représentées sur ces figures est limité. Toutefois, le nombre de couches 24, 26 déposées lors de l'opération 68 est égal au nombre de couches nécessaires pour former le réflecteur 20.

Lors d'une opération 70, le film 32 en silice est déposé sur la couche 24 la plus haute du réflecteur 20 (figure 7). Comme pour les couches 24 et 26, le film 32 est déposé sur toute la surface du substrat 4 et s'étend donc horizontalement au-dessus du plot 30. À ce stade, l'épaisseur du film 32 peut être supérieure à l'épaisseur finale souhaitée.

Ensuite, lors d'une opération 72, la face supérieure du substrat 4 est polie jusqu'à atteindre et mettre à nu la face supérieure du plot 30 (figure 8). Lors de ce polissage, la face supérieure du plot 30 est utilisée comme butée d'arrêt du polissage. Comme le plot 30 est en nitrure de silicium et qu'il est donc beaucoup plus dur que la silice, lors de la fabrication de la source laser 2, le plot 30 permet de garantir que l'épaisseur de l'empilement du réflecteur 20 et du film 32 ne sera pas réduite, même accidentellement, au-delà de l'épaisseur du plot 30. Le plot 30 permet donc en plus de contrôler précisément l'épaisseur du réflecteur 20 et du film 32 réalisés à l'intérieur de la cavité 64.

À ce stade, l'épaisseur du film 32 est égale à l'épaisseur finale souhaitée.

La réalisation de la couche structurée 6 est terminée à l'issue de l'opération 72 et l'étape 52 s'achève.

Ensuite, lors d'une étape 74, l'amplificateur optique 8 est collé, par collage direct, sur la face 14 de la couche structurée (figure 9). Plus précisément, l'électrode 42 est directement collé sur le film 32 et sur la face supérieure du plot 30. Lors de cette étape, le film 32 absorbe l'hydrogène libéré lors de ce collage direct, ce qui renforce la qualité et donc la force de collage de l'amplificateur optique 8 sur la couche structurée 6.

Le réflecteur 10 peut ensuite être déposé sur le sommet de l'amplificateur optique 8.

On obtient alors la source laser 2.

La figure 10 représente une source laser 80 à cavité résonante horizontale. L'architecture générale d'une telle source laser est bien connue et, par exemple, décrite dans l'article suivant : B. Ben Bakir et al., « Hybrid Si/III-V lasers with adiabatic coupling », 2011.

Dans ce mode de réalisation, la couche structurée 6 est remplacée par une couche structurée 82. La couche 82 est identique à la couche structurée 6 sauf que le composant optique passif réalisé à l'intérieur de la cavité 64 est un guide d'onde 84 en silicium amorphe au moins en partie encapsulé dans une couche 86 en silice. Le guide d'onde 84 guide le signal optique le long d'un axe optique horizontal, par exemple, parallèle à la direction Y. Dans l'exemple de mode de réalisation représenté, le guide d'onde 84 présente une structure connue sous le terme anglais de « Rib waveguide ». Ici, il se compose d'une dalle horizontale 88 qui s'étend le long de l'axe optique et d'une bande 90 directement déposée sur la face supérieure de la dalle 88. Typiquement, la dalle 88 et la bande 90 ne forment qu'un seul bloc continu de matière en silicium. La bande 90 s'étend également principalement le long de l'axe optique de ce guide d'onde 84.

Ici, la face supérieure de la bande 90 affleure la face supérieure 14 de la couche structurée 82. Dans ce mode de réalisation, la silice située de part et d'autre de la bande 90 et qui affleure également la face 14 forme un film de silice qui remplit la même fonction que le film 32 précédemment décrit.

Dans la source laser 80, l'amplificateur optique 8 est remplacé par un amplificateur optique 94. L'amplificateur optique 94 présente une structure similaire à celle de l'amplificateur optique 8, sauf qu'il est en plus conformé pour guider le signal optique à la longueur d'onde λ_{Li} horizontalement. Ici, les réflecteurs qui sont situés aux extrémités de la cavité horizontale de la source laser 80 et, typiquement, dans le guide d'onde 84, n'ont pas été représentés. Dans ce mode de réalisation, le guide d'onde 84 est couplé optiquement à l'amplificateur optique 94 par un couplage évanescent.

La figure 11 représente une source laser 100 identique à la source laser 80, sauf que la couche structurée 82 est remplacée par une couche structurée 102. La couche structurée 102 est identique à la couche structurée 82 sauf que le guide d'onde 84 est remplacé par un guide d'onde 103. Le guide d'onde 103 est, par exemple, identique au guide d'onde 84, sauf qu'il est couplé optiquement à l'amplificateur optique 94 par un couplage adiabatique et non plus évanescent. Les couplages adiabatiques sont bien connus. Par exemple, le lecteur peut se référer à l'article suivant pour une description détaillée d'un couplage adiabatique : Amnon Yariv et al., « Supermode Si/III-V hybrid Lasers, optical amplifiers and modulators: proposal and analysis » Optics Express 9147, vol. 14, No. 15, 23/07/2007. À cet effet, dans ce mode de réalisation, la bande 90 est séparée de la face supérieure 14 par un film de silice 104 identique au film 32 précédemment décrit.

De nombreux autres modes de réalisation sont possibles. Par exemple, ce qui a été décrit ici s'applique à tout type de sources laser dans laquelle une région active réalisée dans un matériau III-V est reportée par collage direct sur une couche structurée comportant un ou plusieurs composants optiques encapsulés ou réalisés en silice. Par exemple, ce qui a été décrit s'applique aux sources laser DBR (« Distributed Bragg Reflector laser »), aux sources laser DFB (« Distributed Feed-back laser »), aux anneaux lasers (« Ring laser »), aux sources laser à mode verrouillé (« mode locked laser ») ou aux sources laser réglables («Tunable laser »).

Le composant optique passif n'est pas nécessairement encapsulé dans de la silice. Il peut aussi être réalisé sur une couche de silice et à l'intérieur d'une cavité remplie d'air ou à l'intérieur de laquelle le vide a été réalisé. Dans ce cas, les parois verticales du composant optique passif ne sont pas directement en contact avec de la silice ou un autre matériau solide. Le plot 30 traverse alors la couche de silice sur laquelle est réalisée le composant optique passif. Par exemple, les parois verticales de la cavité à l'intérieur de laquelle est logé le composant optique passif sont celles du plot 30 en nitrure de silicium. Cette situation se rencontre notamment lorsque le composant optique passif est un guide d'onde. A titre d'illustration, cette variante correspond au mode de réalisation décrit en référence à la figure 11 mais dans lequel le film 104 et la silice qui entoure, dans la direction horizontale, le guide d'onde 103 est omise de manière à ce que le guide d'onde 103 repose uniquement sur une couche de silice situé sous lui.

Le réflecteur 20 peut aussi être un cristal photonique.

En variante, si nécessaire, le substrat 4 en silicium peut être aminci.

Dans un autre mode de réalisation, la source laser comporte au moins deux plots ou plus en nitrure de silicium. Dans ce cas, l'amplificateur optique est collé sur les faces supérieures de ces différents plots en nitrure de silicium.

En variante, le film 32 de silice est omis. Par exemple, le film de silice est remplacé par une zone creuse laissée vide comme dans le mode de réalisation décrit dans l'article de Sysak2011.

Dans une autre variante, la gravure de la cavité 64 est arrêtée avant d'atteindre le substrat 4 en silicium. Dans ce cas, le fond de la cavité est formé par une partie amincie de la couche 56 en nitrure de silicium. Dans une autre variante après le dépôt de la couche nitrure 56, la cavité 64 est arrêtée à l'intérieur le substrat 4 en silicium. Dans ce cas, le fond de la cavité 64 se situe en dessous du niveau de la face 16 du substrat 4.

De nombreux autres modes de réalisation de l'amplificateur optique 8 ou 94 sont possibles. Par exemple, l'amplificateur optique peut être réalisé comme décrit dans l'article suivant : Dimitris Fitsios et al. « High-gain 1,3 µm GaInNAs semiconductor optical amplifier with enchanced temperature stability for all-optical processing at 10 Gb/s », Applied optics, may 2015 vol. 54, n°1, 1er janvier 2015.

Les électrodes 42 et 44 peuvent être réalisés dans d'autres matériaux III-V. Par exemple, elles peuvent être réalisées en InP.

En variante, l'électrode 42 s'étend directement sur la face supérieure du plot 30 uniquement dans la direction X ou Y.

## Revendications

1. Source laser à semi-conducteur apte à émettre à au moins une longueur d'onde λ_{Li}, cette source laser comportant :
- un substrat (4) en silicium s'étendant principalement dans un plan appelé « plan du substrat »,
- une couche structurée (6 ; 82 ; 102) formée sur une face supérieure du substrat en silicium et présentant une face supérieure (14) du côté opposé au substrat en silicium, cette couche structurée comportant :
• un composant optique passif (20 ; 84 ; 103) choisi dans le groupe composé d'un réflecteur optique et d'un guide d'onde, ce composant optique passif étant encapsulé dans de la silice ou réalisé sur une couche de silice, et
• au moins un plot (30) s'étendant depuis une face inférieure, en contact direct avec le substrat en silicium, jusqu'à une face supérieure affleurant la face supérieure de la couche structurée, ce plot étant entièrement réalisé dans un matériau dont la conductivité thermique à 20°C est supérieure à la conductivité thermique à 20°C de la silice pour former un pont thermique à travers la couche structurée,
- un amplificateur optique (8 ; 94) en matériau III-V apte à amplifier le signal optique de longueur d'onde λ_{Li} qui le traverse lorsqu'il est alimenté, cet amplificateur optique étant directement collé, par collage direct, sur la face supérieure de la couche structurée au-dessus, dans une direction perpendiculaire au plan du substrat, du composant optique passif de manière à ce que le signal optique amplifié par l'amplificateur optique soit réfléchi ou guidé par ce composant optique passif, cet amplificateur optique étant également directement collé, par collage direct, au moins en partie sur la face supérieure du plot pour dissiper la chaleur qu'il génère vers le substrat en silicium,
**caractérisé en ce que** le plot (30) est réalisé en nitrure de silicium.

2. Source laser selon la revendication 1, dans laquelle la source laser comporte un film (32) en silice d'épaisseur supérieure ou égale à 10 nm situé au-dessus d'au moins une partie du composant optique passif et affleurant la face supérieure (14) de la couche structurée de sorte que l'amplificateur optique est également directement collé sur ce film en silice.

3. Source laser selon la revendication 2, dans laquelle le film en silice recouvre la totalité du composant optique passif.

4. Source laser selon la revendication 2, dans laquelle le composant optique passif est un réflecteur optique (20) comportant un empilement, en alternance dans la direction perpendiculaire au plan du substrat en silicium, de couches (24) en silicium et de couches (26) en silice, cet empilement se terminant par une couche en silice qui affleure la face supérieure de la couche structurée et qui constitue en même temps le film en silice.

5. Source laser selon l'une quelconque des revendications 2 à 3, dans laquelle le composant optique passif est un guide d'onde (103) couplé optiquement à l'amplificateur optique à travers le film en silice par un couplage adiabatique.

6. Procédé de fabrication d'une source laser conforme à l'une quelconque des revendications précédentes, dans lequel le procédé comporte :
- la fourniture (50) d'un substrat en silicium s'étendant principalement dans un plan appelé « plan du substrat »,
- la réalisation (52) d'une couche structurée sur une face supérieure du substrat en silicium et présentant une face supérieure du côté opposé au substrat en silicium, cette couche structurée comportant :
• un composant optique passif choisi dans le groupe composé d'un réflecteur optique et d'un guide d'onde, ce composant optique passif étant encapsulé dans de la silice ou réalisé sur une couche de silice, et
• au moins un plot s'étendant depuis une face inférieure, en contact direct avec le substrat en silicium, jusqu'à une face supérieure affleurant la face supérieure de la couche structurée, ce plot étant entièrement réalisé dans un matériau dont la conductivité thermique à 20°C est supérieure à la conductivité thermique à 20°C de la silice pour former un pont thermique à travers la couche structurée,
- le collage (74) d'un amplificateur optique en matériau III-V apte à amplifier le signal optique de longueur d'onde λ_{Li} qui le traverse lorsqu'il est alimenté, cet amplificateur optique étant directement collé, par collage direct, sur la face supérieure de la couche structurée au-dessus, dans une direction perpendiculaire au plan du substrat, du composant optique passif de manière à ce que le signal optique amplifié par l'amplificateur optique soit réfléchi ou guidé par ce composant optique passif, cet amplificateur optique étant également directement collé, par collage direct, au moins en partie sur la face supérieure du plot pour dissiper la chaleur qu'il génère vers le substrat en silicium,
- **caractérisé en ce que**, lors de la réalisation (52) de la couche structurée, le plot est réalisé en nitrure de silicium.

7. Procédé selon la revendication 6, dans lequel la réalisation (52) de la couche structurée comporte :
- la gravure (62) d'une cavité dans une couche en nitrure de silicium directement déposée sur le substrat en silicium, cette gravure laissant subsister au moins un plot en nitrure de silicium qui s'étend autour de la cavité,
- la réalisation (68) du composant optique passif à l'intérieur de cette cavité, puis
- le dépôt (70) d'un film de silice qui recouvre à la fois la face supérieure du plot en nitrure de silicium et le composant optique passif réalisé dans la cavité, puis
- le polissage (72) de la face supérieure de la couche structurée en utilisant la face supérieure du plot comme butée d'arrêt du polissage.

## Patentansprüche

1. Laserquelle mit Halbleiter, die dazu geeignet ist, mit mindestens einer Wellenlänge λ_{Li} zu emittieren, wobei diese Laserquelle umfasst:
- ein Siliziumsubstrat (4), das sich hauptsächlich in einer Ebene erstreckt, die als "Substratebene" bezeichnet wird,
- eine strukturierte Schicht (6; 82; 102), die auf einer oberen Fläche des Siliziumsubstrats gebildet ist und eine obere Fläche (14) auf der dem Siliziumsubstrat entgegengesetzten Seite aufweist, wobei diese strukturierte Schicht umfasst:
• ein passives optisches Bauelement (20; 84; 103), das aus der Gruppe bestehend aus einem optischen Reflektor und einem Wellenleiter ausgewählt ist, wobei dieses passive optische Bauelement in Siliziumdioxid gekapselt ist oder auf einer Siliziumdioxidschicht ausgeführt ist, und
• mindestens eine Kontaktinsel (30), die sich von einer unteren Fläche in direktem Kontakt mit dem Siliziumsubstrat bis zu einer oberen Fläche erstreckt, die mit der oberen Fläche der strukturierten Schicht bündig ist, wobei diese Kontaktinsel vollständig in einem Material ausgeführt ist, dessen Wärmeleitfähigkeit bei 20 °C höher ist als die Wärmeleitfähigkeit des Siliziumdioxids bei 20 °C, um eine Wärmebrücke über die strukturierte Schicht zu bilden,
- einen optischen Verstärker (8; 94) aus einem III-V-Material, der dazu geeignet ist, das optische Signal mit der Wellenlänge λ_{Li} zu verstärken, das ihn durchläuft, wenn er gespeist wird, wobei dieser optische Verstärker durch direktes Kleben des passiven optischen Bauelements in einer Richtung, die zur Substratebene senkrecht verläuft, direkt auf die obere Fläche der darüberliegenden strukturierten Fläche geklebt ist, so dass das durch den optischen Verstärker verstärkte optische Signal durch dieses passive optische Bauelement reflektiert oder geleitet wird, wobei der optische Verstärker ebenfalls durch direktes Kleben mindestens teilweise direkt auf die obere Fläche der Kontaktinsel geklebt ist, um die Wärme, die er erzeugt, zum Siliziumsubstrat hin abzuführen,
**dadurch gekennzeichnet, dass** die Kontaktinsel (30) in Siliziumnitrid ausgeführt ist.

2. Laserquelle nach Anspruch 1, wobei die Laserquelle eine Siliziumdioxiddünnschicht (32) aus mit einer Dicke größer oder gleich 10 nm umfasst, die sich über mindestens einem Teil des passiven optischen Bauelements befindet und mit der oberen Fläche (14) der strukturierten Schicht bündig ist, so dass der optische Verstärker ebenfalls direkt auf diese Siliziumdioxiddünnschicht geklebt ist.

3. Laserquelle nach Anspruch 2, wobei die Siliziumdioxiddünnschicht die Gesamtheit des passiven optischen Bauelements bedeckt.

4. Laserquelle nach Anspruch 2, wobei das passive optische Bauelement ein optischer Reflektor (20) ist, der einen Stapel mit abwechselnden Siliziumschichten (24) und Siliziumdioxidschichten (26) in einer Richtung senkrecht zur Ebene des Siliziumsubstrats umfasst, wobei dieser Stapel mit einer Siliziumdioxidschicht abschließt, die mit der oberen Fläche der strukturierten Schicht bündig ist und die gleichzeitig die Siliziumdioxiddünnschicht bildet.

5. Laserquelle nach einem der Ansprüche 2 bis 3, bei der das passive optische Bauelement ein Wellenleiter (103) ist, der über die Siliziumdioxiddünnschicht durch adiabatische Kopplung optisch mit dem optischen Verstärker gekoppelt ist.

6. Herstellungsverfahren für eine Laserquelle nach einem der vorhergehenden Ansprüche, wobei das Verfahren umfasst:
- Bereitstellen (50) eines Siliziumsubstrats, das sich hauptsächlich in einer Ebene erstreckt, die als "Substratebene" bezeichnet wird,
- Ausführen (52) einer strukturierten Schicht auf einer oberen Fläche des Siliziumsubstrats, die eine obere Fläche auf der dem Siliziumsubstrat entgegengesetzten Seite aufweist, die dem Siliziumsubstrat entgegengesetzt ist, wobei diese strukturierte Schicht umfasst:
• ein passives optisches Bauelement, das aus der Gruppe bestehend aus einem optischen Reflektor und einem Wellenleiter ausgewählt ist, wobei dieses passive optische Bauelement in Siliziumdioxid gekapselt ist oder auf einer Siliziumdioxidschicht ausgeführt ist, und
• mindestens eine Kontaktinsel, die sich von einer unteren Fläche in direktem Kontakt mit dem Siliziumsubstrat bis zu einer oberen Fläche erstreckt, die mit der oberen Fläche der strukturierten Schicht bündig ist, wobei diese Kontaktinsel vollständig in einem Material ausgeführt ist, dessen Wärmeleitfähigkeit bei 20 °C höher ist als die Wärmeleitfähigkeit des Siliziumdioxids bei 20 °C, um eine Wärmebrücke über die strukturierte Schicht zu bilden,
- Kleben (74) eines optischen Verstärkers aus einem III-V-Material, der dazu geeignet ist, das optische Signal mit der Wellenlänge λ_{Li} zu verstärken, das ihn durchläuft, wenn er gespeist wird, wobei dieser optische Verstärker durch direktes Kleben des passiven optischen Bauelements in einer Richtung, die zur Substratebene senkrecht verläuft, direkt auf die obere Fläche der darüberliegenden strukturierten Fläche geklebt ist, so dass das durch den optischen Verstärker verstärkte optische Signal durch dieses passive optische Bauelement reflektiert oder geleitet wird, wobei der optische Verstärker ebenfalls durch direktes Kleben mindestens teilweise direkt auf die obere Fläche der Kontaktinsel geklebt ist, um die Wärme, die er erzeugt, zum Siliziumsubstrat hin abzuführen,
- **dadurch gekennzeichnet, dass** beim Ausführen (52) der strukturierten Schicht die Kontaktinsel (30) in Siliziumnitrid ausgeführt wird.

7. Verfahren nach Anspruch 6, wobei das Ausführen (52) der strukturierten Schicht umfasst:
- Ätzen (62) einer Vertiefung in einer direkt auf dem Siliziumsubstrat abgeschiedenen Siliziumnitridschicht, wobei dieses Ätzen mindestens eine Siliziumnitrid-Kontaktinsel bestehen lässt, die sich um die Vertiefung erstreckt,
- Ausführen (68) des passiven optischen Bauelements im Inneren dieser Vertiefung, anschließend
- Abscheiden (70) einer Siliziumdioxiddünnschicht, die gleichzeitig die obere Fläche der Siliziumnitrid-Kontaktinsel und das in der Vertiefung ausgeführte passive optische Bauelement bedeckt, anschließend
- Polieren (72) der oberen Fläche der strukturierten Schicht unter Verwendung der oberen Fläche der Kontaktinsel als Endanschlag beim Polieren.

## Claims

1. Semiconductor laser source designed to emit at at least one wavelength λ_{Li}, this laser source comprising:
- a substrate (4) made of silicon extending mainly in a plane called "plane of the substrate",
- a structured layer (6 ; 82 ; 102) formed on an upper face of the silicon substrate and having an upper face (14) on the side opposite to the silicon substrate, this structured layer comprising:
• a passive optical component (20 ; 84 ; 103) chosen from within the group composed of an optical reflector and of a waveguide, this passive optical component being encapsulated in silica or formed on a layer of silica, and
• at least one plug (30) extending from a lower face, in direct contact with the silicon substrate, up to an upper face being flush with the upper face of the structured layer, this plug being entirely formed from a material whose thermal conductivity at 20° C is greater than the thermal conductivity of silica at 20° C so as to form a thermal bridge through the structured layer,
- an optical amplifier (8 ; 94) made of a III-V material designed to amplify the optical signal of wavelength λ_{Li} which is passing through it when it is powered, this optical amplifier being directly bonded, by direct bonding, onto the upper face of the structured layer above - in a direction perpendicular to the plane of the substrate - onto the passive optical component in such a manner that the optical signal amplified by the optical amplifier is reflected or guided by this passive optical component, this optical amplifier also being directly bonded, by direct bonding, at least in part, onto the upper face of the plug in order to dissipate the heat that it generates towards the silicon substrate,
**characterized in that** the plug (30) is made of silicon nitride.

2. Laser source according to Claim 1, in which the laser source comprises a film (32) of silica of thickness greater than or equal to 10 nm situated above at least a part of the passive optical component and being flush with the upper face (14) of the structured layer such that the optical amplifier is also directly bonded onto this silica film.

3. Laser source according to Claim 2, in which the silica film covers the entirety of the passive optical component.

4. Laser source according to Claim 2, in which the passive optical component is an optical reflector (20) comprising a stack, alternating in the direction perpendicular to the plane of the silicon substrate, of layers (24) of silicon and of layers (26) of silica, this stack being terminated by a layer of silica which is flush with the upper face of the structured layer and which, at the same time, constitutes the silica film.

5. Laser source according to either one of Claims 2 and 3, in which the passive optical component is a waveguide (103) optically coupled to the optical amplifier through the silica film by an adiabatic coupling.

6. Method of fabrication of a laser source according to any one of the preceding claims, in which the method comprises:
- the supply (50) of a silicon substrate extending mainly in a plane called "plane of the substrate",
- the formation (52) of a structured layer on an upper face of the silicon substrate and having an upper face on the side opposite to the silicon substrate, this structured layer comprising:
• a passive optical component chosen from within the group composed of an optical reflector and of a waveguide, this passive optical component being encapsulated in silica or formed on a layer of silica, and
• at least one plug extending from a lower face, in direct contact with the silicon substrate, up to an upper face being flush with the upper face of the structured layer, this plug being entirely formed from a material whose thermal conductivity at 20° C is greater than the thermal conductivity of silica at 20° C so as to form a thermal bridge through the structured layer,
- the bonding (74) of an optical amplifier made of a III-V material designed to amplify the optical signal of wavelength λ_{Li} which is passing through it when it is powered, this optical amplifier being directly bonded, by direct bonding, onto the upper face of the structured layer above - in a direction perpendicular to the plane of the substrate - onto the passive optical component in such a manner that the optical signal amplified by the optical amplifier is reflected or guided by this passive optical component, this optical amplifier also being directly bonded, by direct bonding, at least in part, onto the upper face of the plug in order to dissipate the heat that it generates towards the silicon substrate,
**characterized in that**, when the structured layer is formed (52), the plug is made of silicon nitride.

7. Method according to Claim 6, in which the formation (52) of the structured layer comprises
- the etching (62) of a cavity into a layer of silicon nitride directly deposited on the silicon substrate, this etching leaving behind at least one plug made of silicon nitride which extends around the cavity,
- the formation (68) of the passive optical component inside of this cavity, then
- the deposition (70) of a film of silica which covers both the upper face of the silicon nitride plug and the passive optical component formed within the cavity, then
- the polishing (72) of the upper face of the structured layer using the upper face of the plug as end stop for the polishing.
